# EUROPEAN PATENT APPLICATION

(11) **EP 4 806 617 A1**
(43) Date of publication of application: **16.09.2026**
(21) Application number: 24888423.1
(22) Date of filing: 27.09.2024
(51) Int. Cl.: B29C 45/40, B29C 33/42, B29C 33/44, B29C 45/02, B29C 45/37, H01L 21/56

(54) **MOLD, RESIN MOLDING DEVICE, AND METHOD FOR PRODUCING RESIN MOLDED ARTICLE**

(30) Priority: 10.11.2023 JP 2023192153
(71) Applicant: Towa Corporation, Kyoto-shi, Kyoto 601-8105 (JP)
(72) Inventor: KITAHARA, Koichi, Kyoto-shi, Kyoto 601-8105 (JP)
(74) Representative: Winter, Brandl - Partnerschaft mbB
(86) International application number: PCT/JP2024/034628
(87) International publication number: WO 2025/100124

(57) **Abstract**

A molding die (C) includes: a first die (LM) on which to place an object to be molded (Sa); and a second die (UM) with a facing surface (33) facing the first die (LM), the second die (UM) being configured to hold a release film (F) on the facing surface (33), at least one of the first die (LM) and the second die (UM) including: a cavity (MC); and an excess resin storage cavity (11a, 12), the second die (UM) including: a movable member (14a) capable of a forward movement and a backward movement, the forward movement being a movement from the cavity inner surface (12b) into the excess resin storage cavity (11a, 12), the backward movement being a movement backward from the excess resin storage cavity (11a, 12); and a protrusion (15a) disposed in at least a portion of an area which area is around the movable member (14a), the protrusion (15a) protruding from the cavity inner surface (12b) into the excess resin storage cavity (11a, 12).

## Description

### Technical Field

This disclosure relates to a molding die, a resin molding apparatus, and a method for producing a resin molded product.

### Background Art

Substrates with semiconductor chips mounted thereon, for example, are typically sealed up in resin for use as electronic parts. A known resin molding apparatus for sealing up, for example, substrates in resin includes a molding die (see, for example, Patent Literature 1).

Patent Literature 1 discloses a transfer molding apparatus ("molding apparatus" in Patent Literature 1) configured to use a pressing plunger to fill a cavity ("product section" in Patent Literature 1) and a resin reservoir with molten resin and then lower a volume-increasing plunger to increase the volume of the resin reservoir. The transfer molding apparatus is configured to, when lowering the volume-increasing plunger to cause resin to flow from the cavity into the resin reservoir, move air bubbles together with the resin from the cavity to the resin reservoir.

### Citation List

### Patent Literature

Patent Literature 1

### JP 2019-009184 A

### Summary of Invention

### Technical Problem

Although the transfer molding apparatus disclosed in Patent Literature 1 does not use a release film between a die and resin, a resin molding apparatus such as a transfer molding apparatus typically uses a release film to prevent resin from adhering to a die. Suppose that the transfer molding apparatus uses a release film over the resin reservoir. While the resin reservoir has a volume changeable by, for example, pressure from resin having flown in or a rise of the volume-increasing plunger, such a change may cause the corresponding portion of the release film to become slack and creased. A release film may, if having a crease, receive resin in the crease and be entrapped in the resin as cured, making it impossible to appropriately remove such cured resin (which is unnecessary).

The above circumstances have led to a demand for a molding die, a resin molding apparatus, and a method for producing a resin molded product each of which prevents a release film from becoming creased easily and entrapped in cured resin during a resin molding operation.

### Solution to Problem

A molding die as an embodiment of this disclosure includes: a first die on which to place an object to be molded; and a second die with a facing surface facing the first die, the second die being configured to hold a release film on the facing surface, at least one of the first die and the second die including: a cavity configured to contain the object to be molded and receive a molten resin material from a pot; and an excess resin storage cavity having a cavity inner surface and configured to store an excess of the resin material which excess has flown out of the cavity after the cavity receives the resin material, the second die including: a movable member capable of a forward movement and a backward movement, the forward movement being a movement from the cavity inner surface into the excess resin storage cavity, the backward movement being a movement backward from the excess resin storage cavity; and a protrusion disposed in at least a portion of an area of the cavity inner surface which area is around the movable member, the protrusion protruding from the cavity inner surface into the excess resin storage cavity.

A resin molding apparatus as an embodiment of this disclosure includes: the above-described molding die; a mold clamp mechanism configured to clamp and open the molding die; a conveying mechanism configured to convey out of the molding die a resin molded product as the object to be molded as resin-molded and an unnecessary resin portion of the resin material, the resin molded product and the unnecessary resin portion having been separated from each other as a result of opening the molding die after a resin molding operation; and a control section configured to control an operation of an apparatus.

A method as an embodiment of this disclosure for producing a resin molded product is a method for producing a resin molded product with use of the above-described resin molding apparatus, the method including: supplying the object to be molded and the resin material to the molding die; clamping the molding die with use of the mold clamp mechanism; and supplying the molten resin material from the pot into the cavity to resin-mold the object to be molded and letting an excess of the resin material which excess is stored in the excess resin storage cavity press the movable member so that the movable member performs the backward movement in a direction of the cavity inner surface.

### Advantageous Effects

Embodiments of this disclosure provide a molding die, a resin molding apparatus, and a method for producing a resin molded product each of which prevents a release film from becoming creased easily and entrapped in cured resin during a resin molding operation.

### Brief Description of Drawings

Fig. 1 is a diagram schematically illustrating a resin molding apparatus as viewed from above.
Fig. 2 is a diagram schematically illustrating a molding die as viewed from the front.
Fig. 3 is a cross-sectional view illustrating a molding step.
Fig. 4 is a cross-sectional view illustrating a molding step.
Fig. 5 is a cross-sectional view illustrating a molding step.
Fig. 6 is a cross-sectional view illustrating a molding step.
Fig. 7 is a flowchart of a clamp opening operation during a molding step.

### Description of Embodiments

The description below deals with a molding die, a resin molding apparatus, and a method for producing a resin molded product as embodiments of this disclosure with reference to drawings. This disclosure is, however, not limited to the embodiments below, and may be altered variously as long as such alteration falls within the scope of this disclosure.

Substrates with, for example, semiconductor chips mounted thereon (objects to be molded) are sealed up in resin for use as electronic parts. Objects to be molded are sealed up in resin by, for example, a transfer method. The transfer method includes, for instance, placing an object to be molded onto the lower die of a molding die, placing a release film on the upper die of the molding die, supplying resin tablets prepared by compressing powder resin into pots in the molding die, heating the resin tablets to melt the resin tablets, and supplying the molten resin into cavities for resin molding of the object to be molded.

The resin tablets are made of solid resin prepared by compressing resin powder. Heating the resin tablets results in liquid, molten resin. The resin tablets may be made of a thermoplastic resin or a thermosetting resin. A thermosetting resin has a viscosity that decreases when heated. Continuing to heat a thermosetting resin polymerizes and cures the thermosetting resin into a cured resin. As described later, a thermosetting resin is desirable in resin molding and sealing up substrates to be molded on which semiconductor chips are mounted.

### [Configuration of Resin Molding Apparatus]

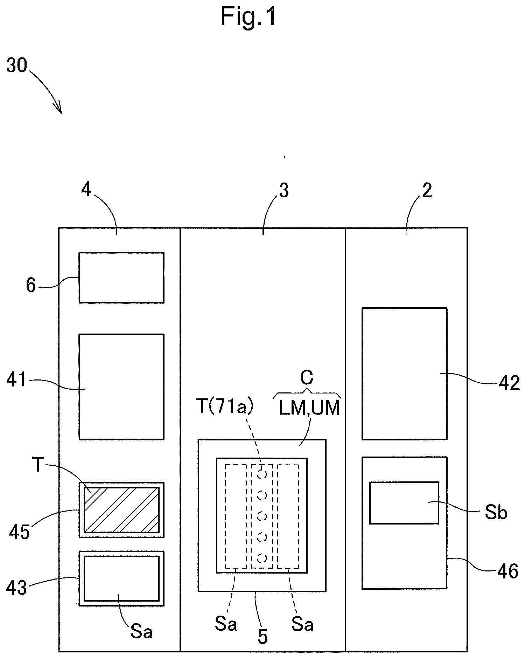

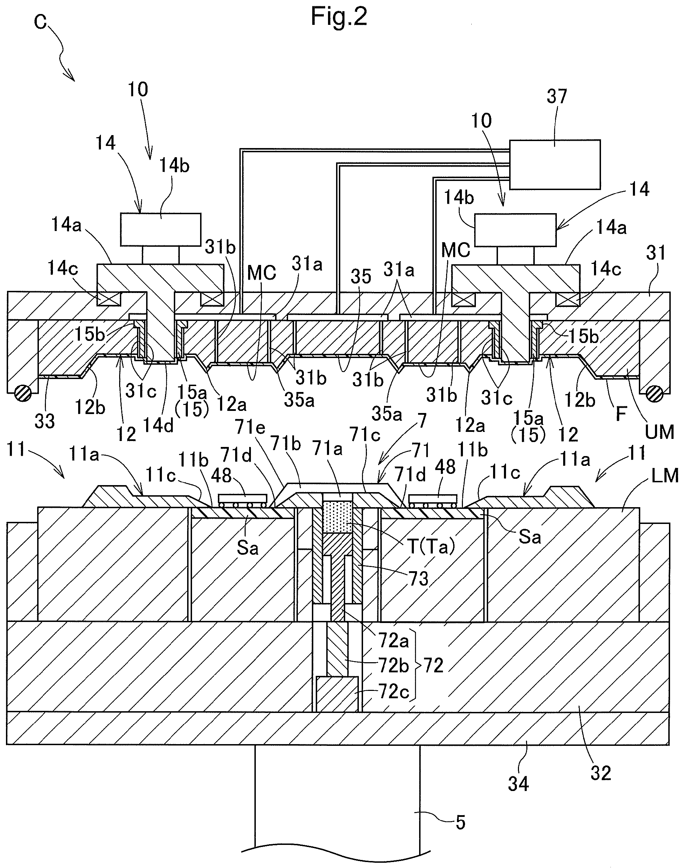

The description below deals as an example with a resin molding apparatus 30 based on a transfer method. Fig. 1 is a diagram schematically illustrating the resin molding apparatus 30 as the present embodiment as viewed from above. The resin molding apparatus 30 includes a container module 2, a molding module 3, a supply module 4, a control section 6, a loader 41, and an unloader 42 (which is an example conveying mechanism). The molding module 3 is configured to seal up objects to be molded in resin and includes a molding die C configured to hold substrates to be molded Sa (which is an example object to be molded). The molding die C includes an upper die UM (which is an example second die) and a lower die LM (which is an example first die). The resin molding apparatus 30 as the present embodiment is configured to resin-mold substrates to be molded Sa on which semiconductor chips 48 (see Fig. 2), for example, are mounted.

The supply module 4 is configured to supply substrates to be molded Sa and resin tablets T (which is an example resin material) to the molding module 3. The supply module 4 includes a substrate supply mechanism 43 and a resin supply mechanism 45. The substrate supply mechanism 43 stores substrates to be molded Sa and aligns the substrates to be molded Sa in a manner suitable for conveyance. Each substrate to be molded Sa is provided with two or more semiconductor chips 48 aligned lengthwise and/or widthwise and mounted. The resin supply mechanism 45 stores resin tablets T in a pattern suitable for conveyance. The substrates to be molded Sa may alternatively be each provided with a single semiconductor chip 48 mounted thereon.

The loader 41 is on standby in the supply module 4. The loader 41 is configured to (i) receive in the supply module 4 substrates to be molded Sa from the substrate supply mechanism 43 and resin tablets T from the resin supply mechanism 45, (ii) move from the supply module 4 to the molding module 3 on a rail (not illustrated in the drawings) extending from the supply module 4 to the molding module 3 and located toward the back (that is, upward in Fig. 1), (iii) transfer the substrates to be molded Sa and the resin tablets T to the lower die LM of the molding module 3, and (iv) move back to the supply module 4 on the rail.

The molding module 3 is configured to seal up substrates to be molded Sa in resin with use of the molding die C to produce molded substrates Sb (which is an example resin molded product). The resin molding apparatus 30 as the present embodiment includes a single molding module 3, but may alternatively include two or more molding modules 3, in which case they are each independently attachable and detachable.

The container module 2 includes a substrate container section 46. The unloader 42 is on standby in the container module 2. The unloader 42 is configured to (i) move to the molding module 3 on a rail (not illustrated in the drawings) extending from the container module 2 to the molding module 3 and located toward the back (that is, upward in Fig. 1), (ii) take out molded substrates Sb from the molding module 3, (iii) move back to the container module 2 on the rail, and (iv) store the molded substrates Sb in the substrate container section 46. Each molded substrate Sb is provided with semiconductor chips 48, for example, sealed up in cured resin resulting from hardening of molten resin Ta (which is an example resin material) (see Fig. 2).

The control section 6 includes a processor such as a central processing unit (CPU) and a storage device such as a random access memory (RAM). The control section 6 is configured such that the processor executes control programs stored in the storage device to control how the resin molding apparatus 30 operates. The resin molding apparatus 30 operates as described below on the basis of operation instructions from the control section 6 unless otherwise specified. The description below basically omits to deal with operation instructions from the control section 6 and deals as necessary with operation instructions from the control section 6.

### [Configuration of Molding Die]

The description below deals with the molding die C of the molding module 3 in detail.

As illustrated in Fig. 2, the molding die C includes an upper die UM, a lower die LM, and a mold clamp mechanism 5. The upper die UM has upper-die cavities MC (which is an example cavity) configured to receive molten resin Ta resulting from heating resin tablets T to melt the resin tablets T. The lower die LM faces the upper die UM and includes a pot block 71 having resin flow paths for supplying molten resin Ta into the upper-die cavities MC. The mold clamp mechanism 5 is configured to clamp the upper die UM and the lower die LM. The molding die C for the present embodiment is configured to (i) receive two substrates to be molded Sa opposite to each other across the pot block 71 of the lower die LM and (ii) resin-mold the two substrates to be molded Sa through a single resin molding operation. This disclosure is, however, not limited to such a configuration. The molding die C may alternatively be configured to resin-mold one substrate to be molded Sa through a single resin molding operation. The mold clamp mechanism 5 operates under control of the control section 6. The loader 41 transfers substrates to be molded Sa to a space between the upper die UM and the lower die LM and places the substrates to be molded Sa on the lower die LM. The substrates to be molded Sa for the present embodiment are rectangular. The upper-die cavities MC are also rectangular as viewed from above accordingly.

The lower die LM is held by a lower-die holder 32, which is in turn fixed to a movable platen 34 configured to be raised and lowered with use of the mold clamp mechanism 5. The mold clamp mechanism 5 for the present embodiment is, for example, a combination of a servomotor and a ball screw mechanism or a combination of an air cylinder or hydraulic cylinder and a rod.

The upper die UM includes an upper-die base plate 31. The upper die UM has a face 33 (which is an example facing surface) facing the lower die LM and configured to receive a release film F from a release film supply mechanism (not illustrated in the drawings). The upper die UM has second flow paths 31b (which is an example suction hole) and third flow paths 31c (which is an example suction hole). A vacuum pump 37 sucks air from the second flow paths 31b and the third flow paths 31c to suck the release film F onto the face 33. The upper die UM has in its edge fourth flow paths (not illustrated in the drawings) as a suction hole. The vacuum pump 37 sucks air from the fourth flow paths to suck the release film F onto the face 33. The vacuum pump 37 sucks air from the second flow paths 31b and the third flow paths 31c via a channel different from the channel via which the vacuum pump 37 sucks air from the fourth flow paths. The release film F is made of a resin material with properties such as heat resistance, releasing property, flexibility, and extensibility. Examples of the resin material include polytetrafluoroethylene (PTFE), ethylene tetrafluoroethylene (ETFE), polyethylene terephthalate (PET), tetrafluoroethylene hexafluoropropylene copolymer (FEP), polypropylene, polystyrene, and polyvinylidene chloride.

The molding die C includes a molten resin supply mechanism 7 including a pot block 71 and a transfer mechanism 72. The pot block 71 has pots 71a configured to receive resin tablets T. The transfer mechanism 72 includes plungers 72a in the respective pots 71a. The resin filler mechanism 7 also includes, for example, cylinders 73 that define the respective pots 71a and that are fitted in respective through holes in the pot block 71.

The pot block 71 includes, at its upper end, first projections 71e each projecting above the molding surface of the lower die LM. The first projections 71e protrude in such a manner as to be capable of pressing a pot-side end portion of each substrate to be molded Sa on the lower die LM. The pot block 71 includes, at its upper surface, cull sections 71b, runners 71c, and first lower gates 71d that together define resin flow paths configured to introduce molten resin Ta from the pots 71a into the upper-die cavities MC. The first projections 71e are each configured such that with the upper die UM and the lower die LM clamped, its upper surface is partially in contact with the upper die UM, and its lower surface and the molding surface of the lower die LM sandwich a substrate to be molded Sa. The first lower gates 71d serve to define resin supply gates, and are located toward the semiconductor chips 48, that is, inward of that edge of each substrate to be molded Sa which is located toward the pot block 71. The description below may use the term "edge-gate method" to refer to a method that includes clamping substrates to be molded Sa on the lower die LM between the lower die LM and the first projections 71e of the pot block 71 for resin molding and supplying molten resin Ta from the pots 71a into the upper-die cavities MC through an area inward of the edge of each substrate to be molded Sa as above.

The transfer mechanism 72 is configured to, with the upper die UM and the lower die LM clamped, move the plungers 72a to supply molten resin Ta from the pots 71a into the upper-die cavities MC. The transfer mechanism 72 includes plungers 72a configured to press molten resin Ta, a fixing block 72b to which the plungers 72a are fixed, and a plunger driving mechanism 72c configured to move the fixing block 72b to move the plungers 72a. The plunger driving mechanism 72c operates under control of the control section 6.

The fixing block 72b is substantially in the shape of a rectangular parallelepiped, and has a rectangular surface (that is, an upper surface) to which the plungers 72a are fixed as arranged in a straight line in correspondence with the respective pots 71a as arranged as described later. The plungers 72a are, for instance, screwed to the fixing block 72b. The fixing block 72b may be provided with a pressure balancing mechanism including, for example, an elastic member configured to cause the individual plungers 72a to press molten resin Ta with a uniform pressure.

The plunger driving mechanism 72c is configured to raise and lower the fixing block 72b relative to the lower die LM to raise and lower all the plungers 72a by an equal amount relative to the respective pots 71a. The plunger driving mechanism 72c for the present embodiment is under the fixing block 72b. The plunger driving mechanism 72c is, for example, a combination of a servomotor and a ball screw mechanism or a combination of an air cylinder or hydraulic cylinder and a rod.

The upper die UM has upper-die cavities MC configured to contain semiconductor chips 48 on substrates to be molded Sa and receive molten resin Ta. The upper die UM also has a depression space 35 and first upper gates 35a both configured to connect the upper-die cavities MC to the cull sections 71b, the runners 71c, and the first lower gates 71d of the pot block 71.

Clamping the upper die UM and the lower die LM with use of the mold clamp mechanism 5 connects the pots 71a to the upper-die cavities MC through the resin flow paths, which are defined by the cull sections 71b, the runners 71c, the first lower gates 71d, the depression space 35, and the first upper gates 35a. Clamping the upper die UM and the lower die LM causes the first lower gates 71d and the first upper gates 35a to define resin supply gates, through which the transfer mechanism 72 supplies molten resin Ta from the pots 71a into the upper-die cavities MC. As described above, the resin supply gates are gaps between the first lower gates 71d and the first upper gates 35a and are inward of that edge of each substrate to be molded Sa which is located toward the pot block 71. Raising the plungers 72a with use of the plunger driving mechanism 72c in the above state causes molten resin Ta to flow into the upper-die cavities MC and seals up, for example, the semiconductor chips 48 on the substrates to be molded Sa in resin. The pot block 71 may alternatively omit the runners 71c, so that the upper-die cavities MC are connected directly to the cull sections 71b through the first lower gates 71d and the first upper gates 35a.

The molding die C includes an excess resin storage mechanism 10 including excess resin storage blocks 11, second excess resin storage cavities 12 (which is an example excess resin storage cavity), movable mechanisms 14, and protrusions 15a. The excess resin storage blocks 11 are each opposite to the pot block 71 across an area of the lower die LM in which area a substrate to be molded Sa is placeable. The second excess resin storage cavities 12 are each opposite to the depression space 35 across an upper-die cavity MC in the upper die UM. The lower die LM has air vents (not illustrated in the drawings) each opposite to the pot block 71 across an excess resin storage block 11.

The excess resin storage blocks 11 each include a first excess resin storage cavity 11a (which is an example excess resin storage cavity), a second lower gate 11b, and a second projection 11c. The first excess resin storage cavity 11a is at such a position of the excess resin storage block 11 as to face the upper die UM. The second lower gate 11b is at an end of the second projection 11c which end corresponds to a portion of the excess resin storage block 11 which portion is the closest to a substrate to be molded Sa.

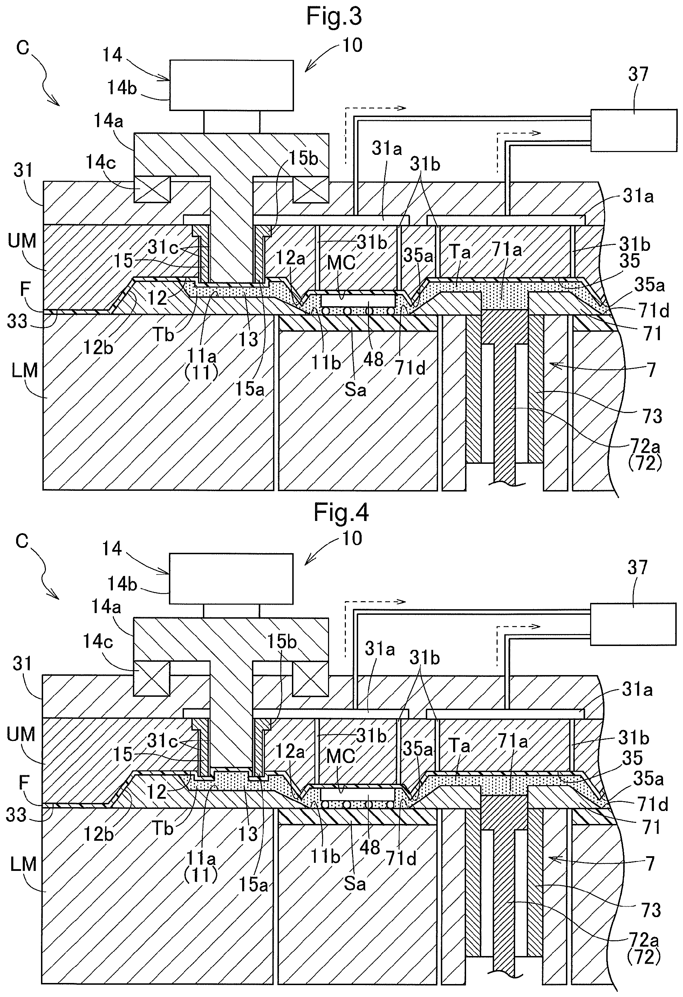

The second excess resin storage cavities 12 each include a second upper gate 12a at a position the closest to the depression space 35. Clamping the upper die UM and the lower die LM with use of the mold clamp mechanism 5 causes the excess resin storage blocks 11 to enter the respective second excess resin storage cavities 12. This causes the first excess resin storage cavities 11a and the second excess resin storage cavities 12 to define an excess resin storage space 13 (see Fig. 3) and the second lower gates 11b and the second upper gates 12a to define resin discharge gates of the edge-gate method that are located toward the semiconductor chips 48, that is, inward of an edge of each substrate to be molded Sa. The second projections 11c are each configured such that with the upper die UM and the lower die LM clamped, its lower surface and the molding surface of the lower die LM sandwich a substrate to be molded Sa.

With the upper die UM and the lower die LM clamped, the transfer mechanism 72 supplies molten resin Ta from the pots 71a into the upper-die cavities MC. In response to the transfer mechanism 72 continuing to supply molten resin Ta into the upper-die cavities MC after molten resin Ta fills the upper-die cavities MC, the upper-die cavities MC discharge excess resin Tb (which is an example resin material) through the resin discharge gates (which are defined by the second lower gates 11b and the second upper gates 12a) into the excess resin storage space 13. Excess resin Tb is molten resin Ta discharged from the upper-die cavities MC into the excess resin storage space 13.

The movable mechanisms 14 each include a movable member 14a, a driver 14b, and a compression spring 14c. The movable member 14a includes a circular column and a flange extending radially outward from an end of the circular column. The circular column extends through the upper die UM and the upper-die base plate 31. The movable member 14a is capable of advancing and receding movement for protruding into the corresponding second excess resin storage cavity 12 and of exit movement for exiting from the second excess resin storage cavity 12. The movable member 14a is, in other words, configured to be capable of a forward movement and a backward movement. The forward movement refers to a movement toward the lower die LM relative to an inner surface 12b of the upper die UM, the inner surface 12b (which is an example cavity inner surface) being a portion of the face 33 which is in the corresponding second excess resin storage cavity 12. The backward movement refers to a movement away from the lower die LM. The inner surface 12b is a surface of the upper die UM which surface is in the corresponding second excess resin storage cavity 12. The flange is above or outward of the upper-die base plate 31. The driver 14b is a motive power source for moving the movable member 14a such as a servomotor or an air cylinder. The compression spring 14c is connected to the upper-die base plate 31 and the flange and configured to, in response to the forward movement of the movable member 14a, apply elastic force to the movable member 14a in a direction away from the lower die LM, that is, in a direction of the backward movement.

The protrusions 15a each protrude from the inner surface 12b of the corresponding second excess resin storage cavity 12 toward the lower die LM. The molding die C as the present embodiment includes a protruding section 15 in the form of a cylinder having an end toward the lower die LM which end serves as a protrusion 15a. The protruding section 15 includes a fixing section 15b disposed at an end opposite to the protrusion 15a and slightly extending radially outward. For example, press-fitting the fixing section 15b with the upper die UM fixes the protruding section 15 to the upper die UM such that that end of the protruding section 15 which faces the lower die LM serves as a protrusion 15a protruding from the corresponding inner surface 12b toward the lower die LM. The protruding section 15 has an inner space in which the corresponding movable member 14a is disposed such that the movable member 14a slides on the inner surface of the protruding section 15. The protruding section 15 is thus in contact with the side surface (that is, the outer surface) of the movable member 14a.

The upper-die base plate 31 has a face in contact with the upper die UM which face has first flow paths 31a each in the form of a groove for passage of air. The first flow paths 31a are connected to the second flow paths 31b and the third flow paths 31c in the upper die UM. The second flow paths 31b are through holes extending from the first flow paths 31a through the upper die UM toward the lower die LM. The second flow paths 31b for the present embodiment have respective ends opposite to the first flow paths 31a which ends are at least in the depression space 35 and the upper-die cavities MC. The third flow paths 31c correspond to a gap between the inner surface of each protruding section 15 and the outer surface of the corresponding movable member 14a and a gap between the outer surface of each protruding section 15 and an inner surface of the upper die UM. The protruding sections 15 each have an end corresponding to the fixing section 15b which end is connected to the corresponding first flow path 31a.

The first flow paths 31a are connected to the vacuum pump 37, which has the function of sucking and supplying air. The vacuum pump 37 sucks air from the first flow paths 31a, the second flow paths 31b, and the third flow paths 31c to suck a release film F onto the face 33 of the upper die UM.

### [Method for Producing Resin Molded Products]

The description below deals with a method for producing a resin molded product (molded substrates Sb) with reference to Figs. 1 to 7. The method for producing a resin molded product (molded substrates Sb) includes a supplying step of supplying a release film F onto the upper die UM and supplying substrates to be molded Sa and resin tablets T onto the lower die LM, a mold clamping step of clamping the molding die C with use of the mold clamp mechanism 5; and a molding step of supplying molten resin Ta from the pot 71a into the upper-die cavities MC to resin-mold the substrates to be molded Sa and letting an excess resin Tb in the excess resin storage space 13 press each movable member 14a so that the movable member 14a performs the backward movement in the direction of the inner surface 12b of the corresponding upper-die cavity MC.

The molding step involves resin molding of substrates to be molded Sa with use of the resin molding apparatus 30 after the resin molding apparatus 30 moves the substrates to be molded Sa into the molding module 3 and before the resin molding apparatus 30 moves molded substrates Sb out of the molding module 3. The molding step for the present embodiment involves supplying molten resin Ta into the upper-die cavities MC and thereby onto the upper face of each substrate to be molded Sa for molding to produce molded substrates Sb. Figs. 3 to 6 each illustrate only that portion of the molding die C which is on one side of the molten resin supply mechanism 7 (that is, the left side of Fig. 2). The portion not illustrated in Figs. 3 to 6 (that is, the right side of Fig. 2) is identical in configuration to the portion illustrated.

As illustrated in Fig. 1, the resin molding apparatus 30 preheats the loader 41 while thermally insulating the space for containing resin tablets T, and also preheats the molding die C. The loader 41 then receives substrates to be molded Sa having been taken out from the substrate supply mechanism 43. The loader 41 also receives resin tablets T as aligned by the resin supply mechanism 45 into the space for containing resin tablets T. The loader 41 conveys the substrates to be molded Sa and the resin tablets T to the molding module 3. The loader 41 positions itself between the upper die UM and the lower die LM of the molding die C and places the substrates to be molded Sa and the resin tablets T onto the lower die LM. The loader 41 then moves from the space between the upper die UM and the lower die LM out of the molding die C and returns to the supply module 4. The molding module 3 causes a heater (not illustrated in the drawings) contained in the lower die LM to heat the resin tablets T in the pots 71a into molten resin Ta. Fig. 2 illustrates substrates to be molded Sa and resin tablets T as placed on the lower die LM.

As illustrated in Fig. 2, the molding module 3 causes a release film supply mechanism (not illustrated in the drawings) to supply an unused release film F to a space between the upper die UM and the lower die LM. The molding module 3 then causes the vacuum pump 37 to suck air from the first flow paths 31a, the second flow paths 31b, the third flow paths 31c, and the fourth flow paths (not illustrated in the drawings) to suck the release film F fixedly onto the face 33 of the upper die UM. In this initial state, the circular column of each movable member 14a has a leading end portion 14d protruding further below (that is, toward the lower die LM) than the leading end (that is, the lowermost end) of the corresponding protrusion 15a. The initial state refers to a state in which the leading end portion 14d of each movable member 14a is not receiving pressure from excess resin Tb.

Next, the mold clamp mechanism 5 causes relative movement of the lower die LM and the upper die UM with a driving force controlled by the control section 6 so that the lower die LM and the upper die UM are closer to each other, and thereby clamps the upper die UM and the lower die LM. The mold clamp mechanism 5 raises the lower die LM and the pot block 71. The pot block 71 stops in response to its upper surface coming into contact with the upper die UM. The mold clamp mechanism 5 raises the lower die LM further. This brings the pot block 71 closer to the lower die LM until (i) the lower surface of each first projection 71e comes into contact with that end of a substrate to be molded Sa which is located toward the pot block 71, and (ii) the lower surface of the second projection 11c of each excess resin storage block 11 comes into contact with that end of the substrate to be molded Sa which is located away from the pot block 71 (mold clamping step). This causes the substrate to be molded Sa to be sandwiched between (i) the respective lower surfaces of the first projection 71e and the second projection 11c and (ii) the molding surface of the lower die LM and thereby fixed to the lower die LM.

The transfer mechanism 72 raises the plungers 72a with a driving force controlled by the control section 6 to supply molten resin Ta (which has resulted from melting the resin tablets T contained in the lower die LM) through the resin supply gates (that is, the gaps between the first upper gates 35a and the first lower gates 71d) into the upper-die cavities MC. As described above, the resin supply gates are located toward the semiconductor chips 48, that is, a portion of each substrate to be molded Sa which portion is located toward the pot block 71.

The transfer mechanism 72 continues to raise the plungers 72a after molten resin Ta fills the upper-die cavities MC. Such molten resin Ta passes through the resin discharge gates (that is, the gaps between the second upper gates 12a and the second lower gates 11b), and is discharged and stored as excess resin Tb in an excess resin storage space 13 defined by the first excess resin storage cavities 11a and the second excess resin storage cavities 12. This causes air, for example, under the semiconductor chips 48 mounted on the substrates to be molded Sa to be discharged into the excess resin storage space 13 together with the molten resin Ta.

After excess resin Tb fills the excess resin storage space 13, the control section 6 controls the driving force of the driver 14b of each movable mechanism 14 appropriately to raise each movable member 14a (that is, a backward movement) until the leading end portion 14d of each movable mechanism 14 is flush with the leading end of the corresponding protrusion 15a. This increases the capacity of the excess resin storage space 13 and moves more excess resin Tb from the upper-die cavities MC into the excess resin storage space 13. The above operation also moves, from the upper-die cavities MC into the excess resin storage space 13, air remaining, for example, under the semiconductor chips 48 or contained in the molten resin Ta in the upper-die cavities MC. This prevents molded substrates Sb (which result from curing the molten resin Ta) from having a void or a filling failure.

The rise of the movable members 14a also raises portions of the release film F; specifically, that portion of the release film F which is in close contact with the leading end portion 14d of each movable member 14a comes into close contact with the inner surface of the corresponding protruding section 15, while that portion which is sucked on each protrusion 15a remains unmoved. This maintains the tension of the release film F after excess resin Tb presses the movable members 14a to move backward, thereby preventing the release film F from becoming slack and creased easily.

The molding module 3 lets the resin (that is, the molten resin Ta and the excess resin Tb) cure with the release film F in close contact with each leading end portion 14d and the inner surface of each protruding section 15 as described above to mold the substrates to be molded Sa (molding step) and thereby produce molded substrates Sb. The above operation prevents the release film F from becoming creased, which in turn prevents the release film F from becoming entrapped in the excess resin Tb as cured.

After the resin is cured, the mold clamp mechanism 5 causes relative movement of the upper die UM and the lower die LM away from each other to open the upper die UM and the lower die LM. During this operation, the control section 6 controls the driving force of the driver 14b of each movable mechanism 14 appropriately while considering the elastic force of the corresponding compression spring 14c. This moves the corresponding movable member 14a forward (that is, toward the lower die LM) in synchronization with the lowering of the lower die LM, specifically, at a speed equal to the speed at which the mold clamp mechanism 5 lowers the lower die LM. This allows the mold clamp mechanism 5 to open the upper die UM and the lower die LM with the release film F sandwiched between each movable member 14a and the cured excess resin Tb. The description below may use the term "cured excess resin Tc" (which corresponds to an example resin material and an example unnecessary resin portion) to refer to excess resin Tb as cured.

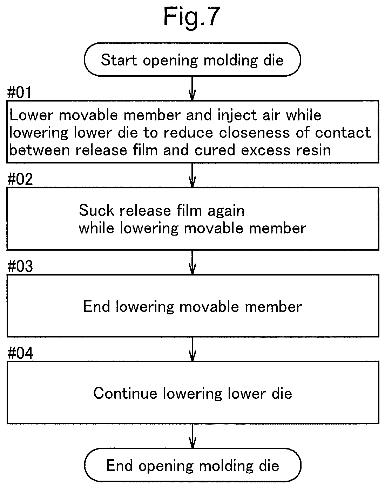

While the mold clamp mechanism 5 is lowering the lower die LM, and each movable mechanism 14 is lowering the corresponding movable member 14a, the vacuum pump 37 injects air into at least the third flow paths 31c (which are connected to the excess resin storage space 13) and the second flow paths 31b (which are connected to the upper-die cavities MC). The vacuum pump 37 is sucking air from the fourth flow paths (not illustrated in the drawings) in the edge of the upper die UM to suck a peripheral portion of the release film F fixedly onto the upper die UM. This causes the release film to balloon and reduces the closeness of the contact between the release film F and the cured excess resin Tc (see step #01 in Fig. 7). The vacuum pump 37 injects air into the third flow paths 31c for a predetermined time period, and then sucks air from the third flow paths 31c to suck the release film F onto the face 33 of the upper die UM (see step #02 in Fig. 7) while the mold clamp mechanism 5 continues to lower the lower die LM, and each movable mechanism 14 continues to lower the corresponding movable member 14a. This further reduces the closeness of the contact between the release film F and the cured excess resin Tc. The vacuum pump 37 may inject air also into the depression space 35 in addition to the excess resin storage space 13 and the upper-die cavities MC.

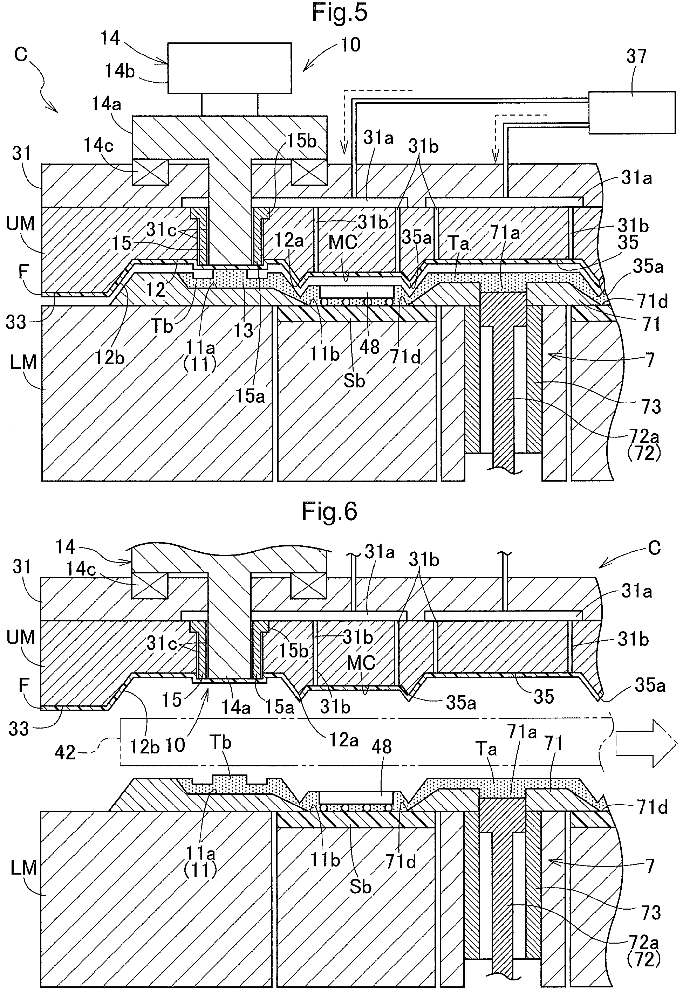

After that, with the release film F sandwiched between each movable member 14a and the cured excess resin Tb, the mold clamp mechanism 5 further lowers the lower die LM, and each movable mechanism 14 further lowers the corresponding movable member 14a until each leading end portion 14d is flush with the leading end of the corresponding protrusion 15a as illustrated in Fig. 5. After that, the mold clamp mechanism 5 further lowers the lower die LM. In response to reaching a predetermined position or the position of the limit of the forward movement, each movable member 14a ends its forward movement (that is, being lowered) (see step #03 in Fig. 7). After that, each movable mechanism 14 does not lower the corresponding movable member 14a, but the mold clamp mechanism 5 does lower the lower die LM (see step #04 in Fig. 7). At this stage, the above operation has sufficiently reduced the closeness of the contact between the release film F and the cured excess resin Tc. Lowering the lower die LM separates the cured excess resin Tc from the release film F and lowers the cured excess resin Tc together with the lower die LM while the cured excess resin Tc is in close contact with the first excess resin storage cavities 11a.

The mold clamp mechanism 5 finishes opening the upper die UM and the lower die LM. The molding module 3 then separates an unnecessary resin portion and cured excess resin Tc on, for example, the cull sections 71b, the runners 71c, and the first lower gates 71d of the pot block 71 from molded substrates Sb (gate break) to separate molded substrates Sb from unnecessary resin. The description herein omits to deal with gate break by a transfer molding apparatus based on the edge gate method, as it is publicly known (see, for example, JP2020-62857A).

After that, as illustrated in Fig. 6, the unloader 42 enters a space between the upper die UM and the lower die LM and conveys, from the molding die C (specifically, the lower die LM), unnecessary resin and cured excess resin Tc to a necessary resin containing section (not illustrated in the drawings) for disposal and the molded substrates Sb to the substrate container section 46 of the container module 2 for storage (see Fig. 1). The packaged substrates (that is, the molded substrates Sb) produced by the resin molding apparatus 30 are cut with use of a cutting device for removal of an unnecessary portion and are singulated. The singulated cut parts are inspected for quality before use as electronic parts.

As described above, the resin molding apparatus 30 as the present embodiment includes an excess resin storage mechanism 10 as well as an upper die UM with movable members 14a and protrusions 15a. This allows a release film F to be in close contact with the inner surface of each protruding section 15 and maintains the tension of the release film F after excess resin Tb presses the movable members 14a to move backward with the release film F sucked on the upper die UM. This prevents the release film F from becoming slack and creased easily, which in turn prevents the release film F from becoming entrapped in the excess resin Tb as cured (that is, cured excess resin Tc). This allows cured excess resin Tc to be separated from the release film F and remain on the lower die LM together with molded substrates Sb when the mold clamp mechanism 5 opens the upper die UM and the lower die LM after the resin molding operation. This removes cured excess resin Tc appropriately for a resin molding operation.

### [Alternative Embodiments]

The description below deals with embodiments alternative to the embodiments described above. For ease of understanding, the description below uses the same terms and reference signs as in the description of the above embodiments for similar elements.
<1> The embodiments described above are configured such that the protrusions 15a each entirely surround the corresponding movable member 14a. The protrusions 15a may alternatively each partially surround the corresponding movable member 14a.
<2> The embodiments described above are configured such that the protruding sections 15 are press-fitted to form protrusions 15a. The protrusions 15a may alternatively be each disposed directly on the upper die UM. Further, the protruding sections 15 may each be welded or otherwise fixed to the upper die UM.
<3> The embodiments described above are configured to supply molten resin Ta from the pots 71a onto substrates to be molded Sa by the edge-gate method, that is, by supplying molten resin Ta into the upper-die cavities MC through an area inward of the edge of each substrate to be molded Sa. This disclosure is, however, not limited to such a configuration, and may alternatively be configured to, for instance, supply molten resin Ta from the pots 71a into the upper-die cavities MC through the edge of each substrate to be molded Sa (which may be referred to as "side-gate method"). The molding die C may, in this case, be configured to discharge excess resin Tb from the upper-die cavities MC into the excess resin storage space 13 by the edge-gate method or the side-gate method.
<4> The embodiments described above are configured such that the lower die LM includes a pot block 71 and excess resin storage blocks 11. This disclosure is, however, not limited to such a configuration, and may alternatively include, in addition to an upper die UM and a lower die LM, an intermediate die including a pot block 71 and excess resin storage blocks 11 so that the pot block 71 and the excess resin storage blocks 11 are between the upper die UM and the lower die LM. The molding die C, in this case, includes three dies, namely, an upper die UM, an intermediate die, and a lower die LM.
<5> The embodiments described above are configured such that the movable members 14a are not receiving pressure from excess resin Tb in the initial state and that in the initial state, the circular column of each movable member 14a has a leading end portion 14d protruding further below (that is, toward the lower die LM) than the leading end (that is, the lowermost end) of the corresponding protrusion 15a. This disclosure is, however, not limited to such a configuration, and may alternatively be configured such that in the initial state, each movable member 14a has a leading end portion 14d flush with the leading end of the corresponding protrusion 15a as illustrated in Fig. 3 or backward of the leading end of the corresponding protrusion 15a. In this case, each protrusion 15a protrudes from the inner surface 12b by an amount not smaller than the amount by which the corresponding movable member 14a protrudes from the inner surface 12b when the upper die UM is holding the release film F. This configuration causes the release film F to, in response to a backward movement of each movable member 14a, extend and come into close contact with the inner surface of the corresponding protruding section 15. Further, the circular column of each movable member 14a may have a leading end portion 14d protruding in the excess resin storage space 13 in the initial state by an amount that depends on the type of object to be molded.
<6> The embodiments described above are configured such that the first excess resin storage cavities 11a and the second excess resin storage cavities 12 define an excess resin storage space 13. This disclosure is, however, not limited to such a configuration, and may alternatively be configured such that the first excess resin storage cavities 11a alone or the second excess resin storage cavities 12 alone define an excess resin storage space 13.
<7> The resin molding apparatus 30 as the above embodiment is configured for resin molding of such substrates to be molded Sa as semiconductor substrates (for example, silicon wafers), metal substrates (for example, lead frames), glass substrates, ceramic substrates, resin substrates, and wiring substrates.
<8> The embodiments described above may be altered to omit (i) steps #01 to #03 in Fig. 7 altogether, (ii) the air injection in step #01 and the second-time suction of the release film in step #02, or (iii) only the lowering of the movable members in steps #01 to #03.

### [Summary of Above Embodiments]

The description below summarizes the molding die (C), the resin molding apparatus (30), and the method for producing a resin molded product (Sb) each described above as an embodiment.

(1) A molding die (C) as the present embodiment characteristically includes: a first die (LM) on which to place an object to be molded (Sa); and a second die (UM) with a facing surface (33) facing the first die (LM), the second die (UM) being configured to hold a release film (F) on the facing surface (33), at least one of the first die (LM) and the second die (UM) including: a cavity (MC) configured to contain the object to be molded (Sa) and receive a molten resin material (Ta) from a pot (71a); and an excess resin storage cavity (11a, 12) having a cavity inner surface (12b) and configured to store an excess of the resin material (Tb) which excess has flown out of the cavity (MC) after the cavity (MC) receives the resin material (Tb), the second die (UM) including: a movable member (14a) capable of a forward movement and a backward movement, the forward movement being a movement from the cavity inner surface (12b) into the excess resin storage cavity (11a, 12), the backward movement being a movement backward from the excess resin storage cavity (11a, 12); and a protrusion (15a) disposed in at least a portion of an area of the cavity inner surface (12b) which area is around the movable member (14a), the protrusion (15a) protruding from the cavity inner surface (12b) into the excess resin storage cavity (11a, 12).

The molding die (C) characteristically configured as above includes a second die (UM) with a protrusion (15a) in at least a portion of the area around the movable member (14a). This allows a release film (F) to be in close contact with the protrusion (15a) and maintains the tension of the release film (F) after the resin material (Tb) presses the movable member (14a) to move backward with the release film (F) sucked on the second die (UM). This prevents the release film (F) from becoming slack and creased easily, which in turn prevents the release film (F) from becoming entrapped in an excess resin material (Tc) as cured. This allows the cured excess resin material (Tc) to be separated from the release film (F) and remain on the first die (LM) together with the substrates to be molded Sa as resin-molded when the mold clamp mechanism (5) opens the second die (UM) and the first die (LM) after the resin molding operation. This removes the cured excess resin material (Tc) appropriately for a resin molding operation.

(2) The molding die (C) according to item (1) above may preferably be further configured such that the protrusion (15a) is disposed in the entire area around the movable member (14a).

With the above configuration, the protrusion (15a) is disposed in the entire area around the movable member (14a). This allows the tension of the release film (F) to be uniform entirely around the movable member (14a), preventing the release film (F) from becoming partially slack or creased easily.

(3) The molding die (C) according to item (1) or (2) above may preferably be further configured such that the protrusion (15a) protrudes from the cavity inner surface (12b) by an amount not smaller than an amount by which the movable member (14a) protrudes from the cavity inner surface (12b) when the second die (UM) is holding the release film (F).

The above configuration reduces that portion of the release film (F) which may become slack, further preventing the release film (F) from becoming creased easily.

(4) The molding die (C) according to any one of items (1) to (3) above may preferably be further configured such that the cavity (MC) receives the resin material (Ta) from the pot (71a) as the resin material (Ta) passes through an area inward of an edge of the object to be molded (Sa).

The above configuration allows the resin material (Ta) to be supplied only to a necessary portion of the object to be molded (Sa).

(5) A resin molding apparatus (30) as the present embodiment characteristically includes: a molding die (C) according to any one of items (1) to (4) above; a mold clamp mechanism (5) configured to clamp and open the molding die (C); a conveying mechanism (42) configured to convey out of the molding die (C) a resin molded product (Sb) as the object to be molded as resin-molded and an unnecessary resin portion (Tc) of the resin material, the resin molded product (Sb) and the unnecessary resin portion (Tc) having been separated from each other as a result of opening the molding die (C) after a resin molding operation; and a control section (6) configured to control an operation of an apparatus.

The resin molding apparatus (30) characteristically configured as above causes the mold clamp mechanism (5) to clamp the molding die (C) according to any one of items (1) to (4) to produce a resin molded product (Sb). This prevents the release film (F) from becoming entrapped in an unnecessary resin portion (Tc) as a cured resin material (Tb). This allows the unnecessary resin portion (Tc) to be separated from the release film (F) and remain on the first die (LM) together with the substrates to be molded (Sa) as resin-molded when the mold clamp mechanism (5) is opened after the resin molding operation. This removes the unnecessary resin portion (Tc) appropriately for a resin molding operation. The conveying mechanism (42) conveys the resin molded product (Sb) and the unnecessary resin portion (Tc) of the resin material appropriately out of the molding die (C).

(6) The resin molding apparatus (30) according to item (5) above may preferably be further configured such that the control section (6), when causing relative movement of the first die (LM) and the second die (UM) to open the molding die (C), causes the movable member (14a) to perform the forward movement into the excess resin storage cavity (11a, 12) in synchronization with the relative movement.

With the above configuration, the control section (6), when causing relative movement of the first die (LM) and the second die (UM) to open the molding die (C), causes the movable member (14a) to perform the forward movement into the excess resin storage cavity (11a, 12) in synchronization. This allows the mold clamp mechanism (5) to open the molding die (C) with the release film (F) sandwiched between the movable member (14a) and the unnecessary resin portion (Tc) of the resin material, preventing the release film (F) from being broken.

(7) The resin molding apparatus (30) according to item (5) or (6) above may preferably be further configured such that the control section (6), when causing relative movement of the first die (LM) and the second die (UM) to open the molding die (C), causes air to be injected from a suction hole (31b, 31c) in the second die (UM) toward the cavity (MC) and the excess resin storage cavity (11a, 12) to separate a portion of the release film (F) from the facing surface (33), the suction hole (31b, 31c) being configured for sucking air to suck and hold the release film (F).

The above configuration reduces the closeness of the contact between the release film (F) and the unnecessary resin portion (Tc) of the resin material when the mold clamp mechanism (5) opens the molding die (C).

(8) The resin molding apparatus (30) according to item (7) above may preferably be further configured such that the control section (6), after causing air to be injected from the suction hole (31b, 31c), causes air to be sucked again to suck the release film (F) onto the facing surface (33) of the second die (UM) again.

The above configuration further reduces the closeness of the contact between the release film (F) and the unnecessary resin portion (Tc) of the resin material.

(9) A method for producing a resin molded product (Sb) with use of a resin molding apparatus (30) according to any one of items (5) to (8) above characteristically includes: supplying the object to be molded (Sa) and the resin material (T) to the molding die (C); clamping the molding die (C) with use of the mold clamp mechanism (5); and supplying the molten resin material (Ta) from the pot (71a) into the cavity (MC) to resin-mold the object to be molded (Sa) and letting an excess of the resin material (Tb) which excess is stored in the excess resin storage cavity (11a, 12) press the movable member (14a) so that the movable member (14a) performs the backward movement in a direction of the cavity inner surface (12b).

The method arranged as above for producing a resin molded product (Sb) uses the resin molding apparatus (30) according to any one of items (5) to (8) above. This prevents the release film (F) from becoming entrapped in a cured resin material (Tc) resulting from curing the resin material (Tb). This allows the cured resin material (Tc) to be separated from the release film (F) and remain on the first die (LM) together with the substrates to be molded (Sa) as resin-molded when the mold clamp mechanism (5) is opened after the resin molding operation. This removes the cured resin material (Tc) appropriately for production of a resin molded product (Sb).

### Industrial Applicability

This disclosure is applicable to a molding die, a resin molding apparatus, and a method for producing a resin molded product.

### Reference Signs List

- 5: Mold clamp mechanism
- 6: Control section
- 11: Excess resin storage block
- 11a: First excess resin storage cavity (excess resin storage cavity)
- 12: Second excess resin storage cavity (excess resin storage cavity)
- 12b: Inner surface (cavity inner surface)
- 14a: Movable member
- 15a: Protrusion
- 31b: Second flow path (suction hole)
- 31c: Third flow path (suction hole)
- 33: Face (facing surface)
- 42: Unloader (conveying mechanism)
- 71a: Pot
- C: Molding die
- F: Release film
- LM: Lower die (first die)
- MC: Upper die cavity (cavity)
- Sa: Substrate to be molded (object to be molded)
- Sb: Molded substrate (resin molded product)
- T: Resin tablet (resin material)
- Ta: Molten resin (resin material)
- Tb: Excess resin (resin material)
- Tc: Cured excess resin (resin material, unnecessary resin portion)
- UM: Upper die (second die)

## Claims

1. A molding die, comprising:
a first die on which to place an object to be molded; and
a second die with a facing surface facing the first die, the second die being configured to hold a release film on the facing surface,
at least one of the first die and the second die including:
a cavity configured to contain the object to be molded and receive a molten resin material from a pot; and
an excess resin storage cavity having a cavity inner surface and configured to store an excess of the resin material which excess has flown out of the cavity after the cavity receives the resin material,
the second die including:
a movable member capable of a forward movement and a backward movement, the forward movement being a movement from the cavity inner surface into the excess resin storage cavity, the backward movement being a movement backward from the excess resin storage cavity; and
a protrusion disposed in at least a portion of an area of the cavity inner surface which area is around the movable member, the protrusion protruding from the cavity inner surface into the excess resin storage cavity.

2. The molding die according to claim 1, wherein
the protrusion is disposed in the entire area around the movable member.

3. The molding die according to claim 1 or 2, wherein
the protrusion protrudes from the cavity inner surface by an amount not smaller than an amount by which the movable member protrudes from the cavity inner surface when the second die is holding the release film.

4. The molding die according to any one of claims 1 to 3, wherein
the cavity receives the resin material from the pot as the resin material passes through an area inward of an edge of the object to be molded.

5. A resin molding apparatus, comprising:
a molding die according to any one of claims 1 to 4;
a mold clamp mechanism configured to clamp and open the molding die;
a conveying mechanism configured to convey out of the molding die a resin molded product as the object to be molded as resin-molded and an unnecessary resin portion of the resin material, the resin molded product and the unnecessary resin portion having been separated from each other as a result of opening the molding die after a resin molding operation; and
a control section configured to control an operation of an apparatus.

6. The resin molding apparatus according to claim 5, wherein
the control section, when causing relative movement of the first die and the second die to open the molding die, causes the movable member to perform the forward movement into the excess resin storage cavity in synchronization with the relative movement.

7. The resin molding apparatus according to claim 5 or 6, wherein
the control section, when causing relative movement of the first die and the second die to open the molding die, causes air to be injected from a suction hole in the second die toward the cavity and the excess resin storage cavity to separate a portion of the release film from the facing surface, the suction hole being configured for sucking air to suck and hold the release film.

8. The resin molding apparatus according to claim 7, wherein
the control section, after causing air to be injected from the suction hole, causes air to be sucked again to suck the release film onto the facing surface of the second die again.

9. A method for producing a resin molded product with use of a resin molding apparatus according to any one of claims 5 to 8,
the method comprising:
supplying the object to be molded and the resin material to the molding die;
clamping the molding die with use of the mold clamp mechanism; and
supplying the molten resin material from the pot into the cavity to resin-mold the object to be molded and letting an excess of the resin material which excess is stored in the excess resin storage cavity press the movable member so that the movable member performs the backward movement in a direction of the cavity inner surface.
